Europäisches Patentamt

European Patent Office

Office européen des brevets

(19)

(11) Numéro de publication: **0 327 446**
**A1**

(12) **DEMANDE DE BREVET EUROPEEN**

(21) Numéro de dépôt: **89400265.8**

(22) Date de dépôt: **31.01.89**

(51) Int. Cl.⁴: **G 06 F 7/62**
H 03 K 5/26, G 01 R 23/10

(30) Priorité: **02.02.88 FR 8801192**

(43) Date de publication de la demande:
**09.08.89 Bulletin 89/32**

(84) Etats contractants désignés: **DE GB IT NL**

(71) Demandeur: **COMMISSARIAT A L'ENERGIE ATOMIQUE**
**31/33, rue de la Fédération**
**F-75015 Paris (FR)**

(72) Inventeur: **Dupoy, Marc**
**21 rue des Morillons**
**F-75015 Paris (FR)**

(74) Mandataire: **Mongrédien, André et al**
**c/o BREVATOME 25, rue de Ponthieu**
**F-75008 Paris (FR)**

(54) **Comparateur numérique, ratiomètre numérique et analyseur d'amplitude comportant de tels ratiomètres.**

(57) Ratiomètre numérique donnant le rapport de deux ou plusieurs grandeurs convertibles en fréquence, utilisant deux ou plusieurs registres identiques (12, 13) qui ont la possibilité de fonctionner en compteur et en registre à décalage à droite. Le décalage à droite du contenu des registres-compteur est subordonné à la saturatiion de l'un quelconque de ces registres-compteurs. Les deux ou plusieurs registres (12, 13) sont incrémentés par les fréquences d'entrée (9,t) et décalés simultanément; il en résulte que le rapport R des contenus (N1, T) des registres-compteur est sensiblement constant dans la mesure ou les fréquences d'entrée (9, t) sont constantes.
Application à un analyseur d'amplitude.

FIG_4

EP 0 327 446 A1

**Description**

## COMPARATEUR NUMERIQUE, RATIOMETRE NUMERIQUE ET ANALYSEUR D'AMPLITUDE COMPORTANT DE TELS RATIOMETRES

La présente invention a pour objet un ratiomètre numérique ainsi qu'un analyseur d'amplitude utilisant de tels ratiomètres. Un ratiomètre est un dispositif qui donne un signal correspondant au rapport de deux grandeurs évolutives. Dans le cas de la présente invention, ces grandeurs sont des fréquences de suites d'impulsions périodiques ou aléatoires.

L'invention trouve particulièrement son application dans le domaine de la mesure et de la surveillance des émissions radioactives où le rapport à présenter concerne la fréquence (division par le temps) de la production d'événements radioactifs. Dans le domaine nucléaire un tel appareil, travaillant dans une seule gamme d'énergie est connu sous le nom de "ictomètre". Dans un analyseur d'amplitude multicanaux, ces événements radioactifs sont d'abord discriminés dans un codeur d'amplitude pour savoir à quelle bande d'énergie ils appartiennent. Dans chaque bande ils sont ensuite comptés au fur et à mesure de leur apparition. La distribution relative des événements dans les différentes bandes d'énergie représente la signature, par exemple le spectre radioactif d'une émission particulière dont on étudie la nature. Le nombre de coups enregistrés , dans chaque bande, la bande où ce nombre est maximal ainsi que l'évolution dans le temps de cette bande, renseignent quantitativement et qualitativement sur le corps radioactif analysé.

L'invention a pour objet un perfectionnement des dispositifs qui délivrent ces résultats dans le domaine radioactif ; elle peut néanmoins être appliquée à d'autres domaines. En particulier le ratiomètre peut être appliqué au calcul du rapport de deux grandeurs quelconques évolutives dans le temps.

Le comptage d'événements nucléaires se produisant dans une gamme d'énergie donnée nécessite une mise à zéro préalable d'un compteur, un déclenchement de ce compteur, et un arrêt de ce compteur au bout d'une durée donnée. Ces opérations sont d'une part fastidieuses et d'autre part provoquent des défauts de précision des mesures ainsi effectuées. En effet, le fait de devoir figer le résultat de la mesure au bout d'une durée donnée impose que ce résultat ne peut être connu qu'à une fluctuation statistique près. L'effet de cette fluctuation statistique, d'une mesure à l'autre, peut altérer sensiblement la précision des résultats. Enfin, les résultats ne sont connus que périodiquement, après la fin d'un temps de comptage présélecté.

De manière à résoudre ce problème il a été proposé, dans une demande de brevet français n° 85 10173 déposée le 3 Juillet 1985, un "Procédé d'utilisation d'un registre binaire à n cellules bistables permettant de déterminer le rapport de deux fréquences et un dispositif pour la mise en oeuvre du procédé". Dans cette demande de brevet, applicable à un même domaine, le compteur chargé de comptabiliser les événements dans une gamme d'énergie donnée est d'un type bien particulier. En simplifiant l'explication, il est un registre compteur binaire progressant de droite à gauche, selon une loi $\log_2$, par une entrée dite de comptage, et comportant des moyens pour faire une division consistant et un décalage vers la droite. Les notions de décalage à droite ou à gauche se justifient dans le sens où les valeurs de poids faible d'un résultat sont habituellement présentées, dans la culture occidentale, à droite du nombre qui représente ce résultat tandis que les valeurs de poids fort sont présentées à gauche. L'incrémentation d'un tel registre monté en compteur s'effectue donc à partir de la droite et chaque case du registre est en relation à droite et à gauche avec des cases de poids décalé. Dans le cas le plus général les registres sont de type binaire, et chaque case peut comporter un état 0 ou un état 1. La modification du contenu d'une case provoque, quand il passe d'un état 1 à un état 0, c'est-à-dire une fois sur deux, l'incrémentation du contenu de la case qui se trouve immédiatement à gauche de cette case. Le décalage du contenu des cases de ce registre vers la droite correspond à une division : en mode binaire, et quand le décalage à droite est un décalage d'une case, la division est une division par deux.

On a pu montrer dans ce mode de fonctionnement, avec un signal A incrémentant le compteur et un signal B provoquant périodiquement le décalage à droite, que le contenu du compteur se stabilise à une valeur N caractéristique de A/B. Ce rapport est compris entre 1 et $2^{n-1}$, n étant égal au nombre de cellules du compteur. On pourrait montrer que ce type de mesure qui évite de figer le résultat au bout d'une durée particulière de mesure permet de minimiser les effets des fluctuations statistiques.

Néanmoins le ratiomètre ainsi conçu délivre un signal qui oscille avec le temps. En effet, même dans l'hypothèse d'une stabilité des deux signaux d'entrée, le registre de comptage donne une mesure qui évolue entre N/2 et N pendant la période de mesure. Immédiatement avant l'opération de décalage à droite du contenu du registre, le registre contient l'information N, immédiatement après il contient l'information N/2. Si on veut éviter cette fluctuation le résultat contenu dans le registre avant ou après le décalage à droite doit être stocké dans un registre tampon, jusqu'au prochain décalage à droite, et constituer le résultat présenté.

Un tel appareil possède une dynamique de mesure qui est essentiellement liée au nombre de cases du registre à décalage utilisé, la gamme de mesure étant liée à la fréquence des décalages à droite. Pour la réalisation d'un ictomètre avec décalage commandé par une horloge, on conçoit pour des radioactivités importantes, où le nombre d'événements ou de coups par seconde est grand, qu'il est nécessaire d'utiliser une horloge rapide si on ne veut pas avoir un temps de réponse prohibitif. A l'opposé, avec une radioactivité faible, si l'horloge est trop rapide, le contenu du registre sera toujours nul parce que trop fréquemment décalé à droite, c'est-à-dire en définitive remis à zéro.

L'utilisation d'une horloge à fréquence ajustable pour, dans une gamme de mesure, disposer d'un appareil ainsi conçu avec une dynamique suffisamment grande, est une solution mais une solution complexe.

En outre, dans le cas où la période entre les décalages à droite du registre est longue, on ignore la variation du signal analysé pendant cette période. Si, par exemple, la durée de cette période est de l'ordre de plusieurs minutes, le registre à décalage s'incrémentant régulièrement au cours de cette durée ne révélera son état, éventuellement anormalement élevé, qu'à l'issue de cette durée.

En résumé, les appareils numériques connus à ce jour, analyseurs multicanaux ou ictomètres (monocanaux) ne délivrent l'information numérique qu'à des instants déterminés, dont l'espacement temporel peut être important, voire incompatible avec la nature des grandeurs que l'on surveille.

L'invention a pour objet de remédier à ces inconvénients en prévoyant un ratiomètre numérique perfectionné, ainsi qu'un analyseur multicanaux muni de tels ratiomètres, dont l'utilisation est simple, dont le signal de sortie est stable pendant la durée d'acquisition de la mesure, et dont la dynamique de mesure est auto-adaptable aux activités rencontrées tout en restituant un signal normé, c'est-à-dire que les activités sont présentées directement dans l'unité choisie, Becquerels par exemple, les canaux n'étant plus de simples compteurs, mais des ictomètres numériques.

En plus de son utilisation normale un analyseur selon l'invention, intégré dans un système de mesure ou de pilotage, peut être utilisé en mode esclave c'est-à-dire qu'il communique ses résultats lorsqu'on les lui demande, quels que soient l'instant et la fréquence de ces demandes. Il peut, fonctionner aussi en mode maître c'est-à-dire avertir spontanément et immédiatement du dépassement par la mesure, sur au moins une de ses voies, d'un seuil prédéterminé.

Le principe de l'invention repose schématiquement sur l'utilisation d'un deuxième registre identique au premier, à progression à gauche pour le comptage et à décalage à droite pour la division. Il possède la possibilité de fonctionner simultanément en compteur et un registre à décalage à droite. Le décalage à droite du contenu des deux registres est subordonné à la saturation de l'un quelconque de ces deux registres. Celui des deux registres qui, arrivant le premier à saturation, provoque le décalage est appelé registre menant. L'autre est le registre mené. Les deux registres étant incrémentés par des fréquences $F_A$ et $F_B$, et décalés simultanément il en résulte que le rapport de leurs contenus $N_A/N_B$ est sensiblement constant, dans la mesure où $F_A$ et $F_B$ sont constantes. Ce rapport peut évoluer de $F_A/F_B = n_A/2$ à $F_B/F_A = n_B/2$ ; les valeurs $n_A$ et $n_B$ représentant la capacité des registres A et B. Tout se passe comme si le rapport des deux fréquences pouvait être plus grand ou plus petit que 1, alors que dans le brevet cité, la fréquence de comptage ne pouvait pas être inférieure à la fréquence de décalage. On remarquera qu'il n'est pas nécessaire que la capacité des deux registres, généralement exprimée en puissance de 2, soit identique.

Un tel montage peut être directment utilisé, par exemple, pour la réalisation d'un appareil permettant la comparaison, ou l'asservissement de deux grandeurs, sous réserve que ces grandeurs puissent être converties en deux fréquences qui leurs sont propositonnelles.

Une autre possibilité de l'invention est, dans le domaine nucléaire, la réalisation d'un ictomètre numérique. Dans ce cas, une des voies de comptage reçoit les impulsions d'un capteur de radioactivité, et l'autre, une fréquence horloge de référence. Si l'on associe cet ictomètre avec un des dispositifs d'affichage décrit dans le brevet cité, ou avec un circuit diviseur inclus entre les deux registres, on obtient directement l'activité dans l'unité choisie, Becquerels ou concentration maximale admissible (CMA) par exemple.

Dans l'explication qui précède, on s'est limité à un circuit ne comportant que deux registres, A et B. Il est bien entendu qu'un tel montage, selon l'invention, peut comporter de nombreux registres A, B, C, D ... x, comparant entre elles des fréquences $F_A$, $F_B$, $F_C$, $F_D$ ... $F_x$. Le registre menant étant celui des registres qui arrive le premier à saturation, provoque le décalage à droite du contenu de l'ensemble des registres, y compris son propre contenu. Dans un tel montage, si les fréquences d'entrée sont constantes, le rapport du contenu d'un registre unique, pris comme référence, avec le contenu de chacun des autres registres demeure constant.

L'invention a donc pour objet un comparateur numérique comportant :
- un premier registre muni d'une entrée dite de comptage pour recevoir et comptabiliser les impulsions d'un premier signal impulsionnel représentatif d'une grandeur fixe ou évolutive, et d'une entrée dite de décalage à droite pour effectuer une division du nombre des impulsions comptabilisées, caractérisé en ce qu'il comporte :
- un deuxième registre identique au premier pour recevoir un deuxième signal impulsionnel représentatif d'une deuxième grandeur fixe ou évolutive, et
- un dispositif pour provoquer le décalage à droite quasiment simultané du contenu de l'ensemble des registres dès qu'au moins un des registres arrive à saturation.

Dans un perfectionnement, l'invention comporte plusieurs registres identiques aux premiers et comptabilisant des impulsions correspondant à une troisième, une quatrième ... etc... grandeur fixe ou évolutive.

Dans un autre perfectionnement le comparateur comporte des moyens pour afficher la division du nombre des impulsions comptabilisées dans un registre à celui des impulsions comptabilisées dans un autre registre, ce qui le transforme en un ratiomètre. Les moyens de présentation du comparateur peuvent alors être ceux énumérés dans la demande de brevet précitée. Leur principe est que le "1" de rang le plus à gauche, (ou de poids le plus élevé), si on compte de droite à gauche, représente par défaut le logarithme à base 2 du contenu du registre. Il le représente exactement s'il est le seul "1" du registre. Ces moyens de représentation peuvent être aussi la liaison à un système informatique ou peuvent être un dispositif qui, après division du contenu du ou des registres par le contenu du registre choisi comme registre de référence, présente les résultats sur un afficheur approprié, un tube cathodique par exemple.

Dans un autre perfectionnement de l'invention on prend en compte le fait que le décalage à droite du contenu des registres faisait sauter statistiquement, en mode binaire, une fois sur deux, la valeur de poids le plus faible contenue dans ce registre. Ceci revient à enlever en moyenne la valeur de 1/2 au contenu du registre à chaque opération de décalage à droite. Pour pallier cet inconvénient et rétablir la justesse de la mesure, dans le ratiomètre de l'invention on incrémente, juste avant le décalage à droite, d'une unité tous les registres à décaler. Cette addition d'une grandeur unité suivie d'une division par deux (résultant du décalage à droite) est équivalente alors à une addition systématique d'une grandeur 1/2. L'enlèvement et l'ajout successif de cette valeur 1/2 se neutralisent alors mutuellement, restituant ainsi sa juste valeur au signal mesuré.

L'invention sera mieux comprise à la lecture de la description qui suit relative à la réalisation d'un analyseur d'amplitude multicanaux et à l'examen des figures qui l'accompagnent. Celles-ci ne sont données qu'à titre indicatif et nullement limitatif de l'invention. Les figures montrent :

  - figures 1 à 3 : des diagrammes temporels et énergétiques de signaux analysés dans un analyseur selon l'invention dans le domaine de la radioactivité ;
  - figure 4 : un schéma fonctionnel d'un ratiomètre numérique selon l'invention ;
  - figure 5 : un analyseur d'amplitude muni de ratiomètres numériques selon l'invention.

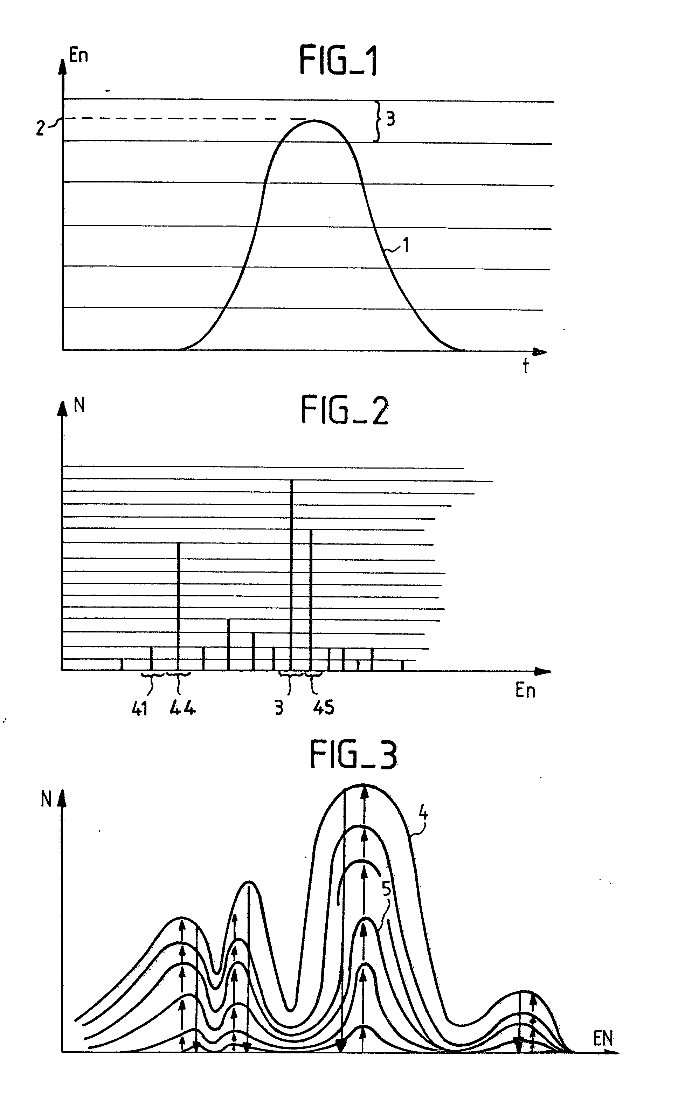

Les figures 1 à 3 montrent des diagrammes temporels, figure 1, et énergétiques, figures 2 et 3, d'un signal à analyser par un analyseur d'amplitude selon l'invention. Un événement radioactif constitué par exemple par l'émission d'un photon γ est détecté par un scintillateur qui réémet, par excitation, d'autres photons détectables par un tube photo-multiplicateur. Le signal électrique temporel disponible à la sortie du tube photo-multiplicateur a une allure impulsionnelle 1 telle que représentée sur la figure 1. Il culmine en amplitude à une valeur 2 correspondant à une gamme d'énergie 3 représentative de l'énergie du photon initial. Un analyseur d'amplitude comporte un codeur d'impulsions, analogique numérique, qui a pour objet de répartir, comme l'indique la figure 2, les événements radioactifs en fonction de leur énergie. Il comporte aussi un ensemble de compteurs, chaque compteur étant affecté à une bande d'énergie de valeur donnée. Par exemple sur la figure 2, la bande 3 montre le nombre N d'événements radioactifs appartenant à la bande d'énergie correspondant au pic du signal. D'une manière habituelle le nombre N peut être codé sur 16 à 32 bits tandis que les énergies peuvent être codées sur 8 à 14 bits. En pratique on peut disposer ainsi de 256 canaux à 16 K canaux, (K = 1024), ou voies, ou encore gammes d'énergies différentes, tandis que la capacité de comptage du nombre d'événements dans une gamme donnée, peut s'étaler sur 16 à 32 bits.

La figure 3 montre l'évolution de l'enveloppe du signal disponible en sortie d'un analyseur d'amplitude classique en fonction du temps. En effet sur une période de mesure, par exemple de quelques heures, le spectre d'une émission se développe progressivement et homothétiquement jusqu'à un maximum 4. Ce maximum 4 est l'état de l'analyseur quand une remise à zéro des compteurs de toutes les voies permet de recommencer la mesure. Un tel analyseur comprend donc de nombreux compteurs de coups faisant apparaître comme signal de sortie exploitable la courbe enveloppe 4. De cette manière on permet la reconnaissance du spectre affiché pour conduire à la détermination de la nature de l'émission. Dans l'invention, mais bien que cela ne soit pas une obligation, les signaux évoqués sont des signaux correspondant à ce type de détection d'émissions radioactives.

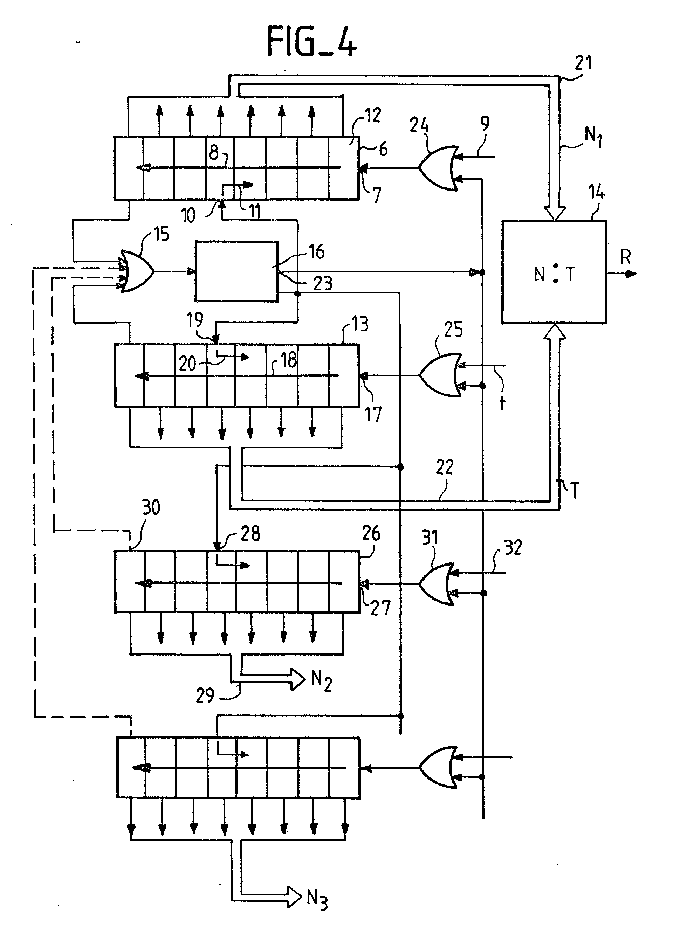

La figure 4 représente le schéma fonctionnel d'un ratiomètre selon l'invention. Ce ratiomètre comporte un premier registre 6 muni d'une entrée 7 dite de comptage par décalage à gauche 8, pour recevoir un premier signal 9 de type impulsionnel, et pour comptabiliser les impulsions reçues. Le registre 6 comporte en outre une entrée 10, dite de décalage à droite 11, pour effectuer une division du nombre des impulsions comptabilisées. En effet l'admission des impulsions du signal 9 à l'entrée 7 pendant une durée donnée a pour résultat qu'à l'issue de cette durée le registre 6 contient dans ses cases telles que 12 un contenu représentatif du nombre des impulsions comptabilisées. Le décalage à droite au moyen d'une entrée 10 de décalage à droite permet de faire une division du contenu du registre 6 qui dépend d'une part du mode de comptage dans le registre (en général un mode binaire) et d'autre part du nombre de cases de décalage à droite (en général une case : ce qui est équivalent à une division par deux).

Une des caractéristiques importantes de l'invention est que les moyens pour obtenir le résultat R comportent un deuxième registre 13 identique au registre 6. Ce registre 13 comporte une entrée 17 pour recevoir un deuxième signal impulsionnel (représentatif par exemple du temps t dans le cas où le ratiomètre accomplit une fonction ictomètre) et pour comptabiliser par progression à gauche 18, ces T impulsions de temps. Il comporte en outre une autre entrée 19 de décalage à droite 20 pour effectuer aussi une division des impulsions comptabilisées représentatives de la deuxième grandeur évolutive : ici le temps. Comme les signaux 9 et t évoluent dans le temps, un diviseur 14 reçoit, par exemple par des bus respectifs 21 et 22, en provenance des registres 6 et 13, les contenus N et T de ces registres représentatifs des impulsions comptabilisées. Le diviseur 14, qui peut être de type numérique ou analogique, effectue alors le rapport de ces deux nombres. Dans la mesure où l'activité détectée, ou le signal 9, est sensiblement constante, le résultat R produit par le diviseur 14 est constant. Cette constance se produit quel que soit l'instant auquel on provoque simultanément le décalage à droite des deux registres 6 et 13, du moment que ce décalage à droite est effectué au plus tard dès que l'un de ces deux registres a atteint sa saturation.

Ce montage de la figure 4 permet donc de s'affranchir de la fluctuation qui apparaissait dans le ratiomètre décrit dans la demande de brevet français 8510173.

Dans ce montage de la figure 4, on provoque le décalage à droite de ces deux registres au moyen d'une port OU 15. La porte 15 reçoit comme information le basculement du bit de poids le plus fort de chacun des registres 6 et 13. Le premier de ces registres qui arrive en saturation transmet alors son signal de basculement à la porte OU 15 et celle-ci délivre en même temps aux entrées 10 et 19 de décalage à droite de chacun de ces deux registres respectivement les ordres 11 et 20 de décalage à droite. Ces ordres ont pour effet de diviser par deux, dans le cas d'un registre binaire, le contenu de chacun de ces deux registres. Il est à remarquer que cette procédure qui élimine complètement les effets des différences de dynamique des activités des émissions à analyser ne modifie en rien le résultat disponible à la sortie du diviseur 14. En effet avant et après le décalage à droite simultané le rapport des nombres N et T est inchangé puisque après ce décalage chacun de ces nombres a été divisé par deux.

On a expliqué précédemment que la division par deux, en mode binaire, avait pour effet de faire perdre statistiquement et systématiquement une valeur 1/2 à chacun des nombres N et T. Dans un perfectionnement, dans le but de compenser cette perte statistique, le décalage à droite des registres 6 et 13 n'est effectué qu'après qu'une unité de valeur de poids le plus faible ait été ajoutée dans chacun des registres 6 et 13. Par exemple un circuit de compensation 16 qui reçoit l'information de saturation de l'un des deux registres 6 ou 13 en provenance de la porte OU 15 émet sur une de ses sorties 23 une impulsion qui est transmise par des portes OU, respectivement 24 et 25 sur les entrées de comptage respectivement 7 et 17 des registres 6 et 13. Les portes OU 24 et 25 permettent la prise en compte sur ces entrées 7 et 17 de l'un des signaux 9 et t d'une part ou d'une impulsion de compensation d'autre part. Une fois que cette impulsion de compensation a été introduite dans les registres 6 et 13 l'impulsion de décalage à droite leur est appliquée. Il est nécessaire que cette impulsion de décalage à droite soit faite ultérieurement à l'application de l'impulsion de compensation. On peut néanmoins envisager d'effectuer le décalage à droite avant d'envoyer l'impulsion de compensation. Dans ce cas il convient de n'envoyer une impulsion de compensation qu'un décalage à droite sur deux.

Le registre 6 qui a été présenté convient par exemple pour la comptabilisation des événements qui se sont produits dans la bande 3 d'énergie (figure 2) et la description précédente concerne en fait un ictomètre travaillant dans une telle bande d'énergie. Un analyseur d'amplitude comporte bien entendu beaucoup plus de voies. On a dit que les niveaux d'énergie pouvaient être codés sur 8 à 14 bits. Ceci signifie que l'analyseur peut comporter de 256 à 16K voies soit 256 à 16K registres tels que le registre 6. Tous ces registres, par exemple le registre 26, comportent une entrée de comptage, décalage à gauche 27, une entrée de décalage à droite 28, un bus 29 de transmission de l'état du registre, et un sortie 30 de la case de poids le plus fort reliée à la porte OU 15 pour indiquer si ce registre est le premier en saturation. De même que précédemment, une porte logique OU 31 permet de prendre en compte soit le signal 32 de la voie à mesurer soit l'impulsion de compensation du décalage à droite.

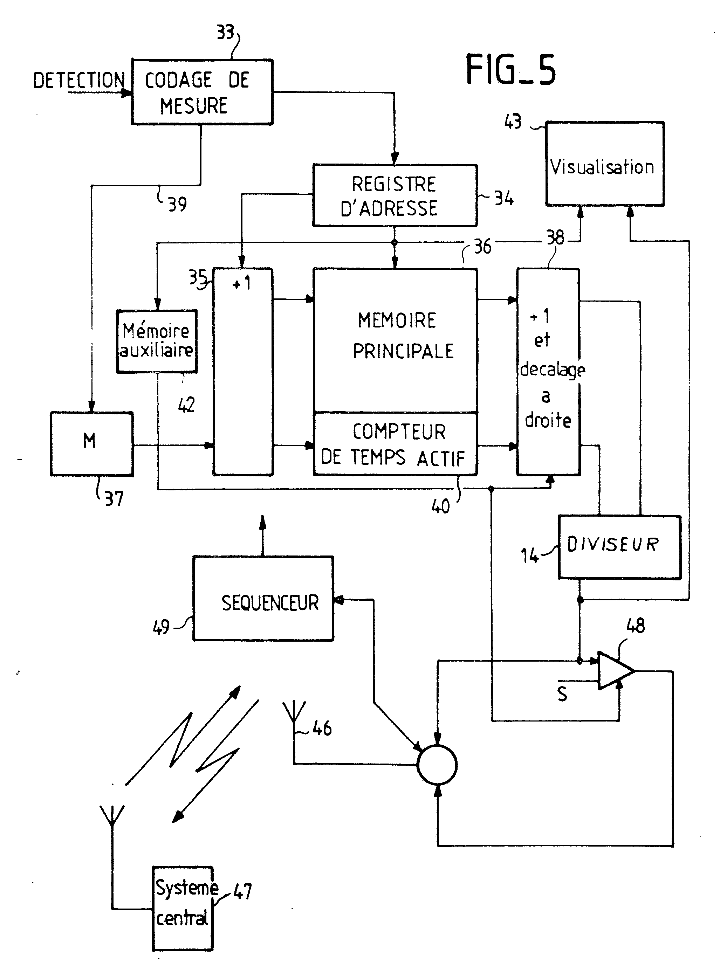

Le schéma de la figure 4 n'est qu'un schéma fonctionnel. Dans la pratique bien entendu la porte 15, le circuit de compensation 16 et les portes OU 24, 25 et 31 peuvent être remplacées par des instructions logiques qui exécutent les mêmes fonctions. La figure 5 montre une architecture plus réaliste d'un analyseur d'amplitude comportant des ratiomètres fonctionnant en ictomètres selon l'invention. Les signaux à détecter apparaissent à l'entrée du discriminateur 33 de bande d'énergie. Le discriminateur 33 délivre un signal, code une adresse, correspondant à la mesure de la bande d'énergie dans laquelle l'impulsion correspondant à l'événement radioactif a culminé. Un registre d'adresse 34 reçoit l'adresse codée. Il est en relation avec un registre d'écriture 35 qui incrémente, dans une mémoire 36 et à l'adresse considérée, la valeur d'une unité. Dans ce but, le registre d'écriture 35 comporte une instruction, précablée ou préprogrammée +1. A l'adresse de la case mémoire imposée par le registre d'adresse 34 on retrouve donc la comptabilisation de tous les événements radioactifs qui ont correspondu à cette bande d'énergie.

Les registres considérés jusqu'à maintenant sont donc ainsi reduits à leur plus simple expression : ils sont constitués de cases mémoires, de 16 à 32 bits selon les cas. En général les faibles bandes d'énergie sont inutilisables dans des analyses spectrales. Autrement dit la mémoire 36 dispose de cases mémoires dont les adresses correspondent à ces bandes de basse énergie et qui ne sont pas utilisées. On peut utiliser alors une de ces cases mémoires pour constituer le registre 13 représentatif du temps de mesure. L'incrémentation de ce compteur de temps peut être faite directement, à travers le registre d'écriture 35, à partir d'une horloge 37 puisque son adresse est toujours la même.

Au moyen d'un registre de lecture 38 on peut prélever les contenus de toutes les cases mémoires de la mémoire ainsi que le contenu du compteur de temps pour effectuer dans un diviseur 14 le rapport des activités dans chaque bande d'énergie par rapport au temps. En pratique, le registre de lecture 38 est confondu avec le registre d'écriture 35 qui devient un registre d'écriture et de lecture. La représentation de la figure 5 permet seulement de séparer simplement les fonctions.

Le registre 35-38 est muni d'une détection de saturation des registres contenus dans la mémoire 36. Quand une saturation sur un registre quelconque est détectée, une instruction +1 suivie d'un décalage à droite de tous ces registres est entreprise. La détection de la mise en saturation de l'un quelconque des registres correspond à la fonction de l'un quelconque des registres correspond à la fonction de la porte OU 15. L'instruction +1 suivie du décalage à droite correspond à la compensation statistique et à la division par deux, comme déjà expliqué page 8, ligne 20 à page 9 ligne 2.

L'analyseur d'amplitude de l'invention comporte cependant trois autres perfectionnements. Dans un premier perfectionnement on tient compte d'un temps dit actif. En effet la discrimination par le détecteur 33 de la gamme d'énergie dans laquelle a culminé l'impulsion 1 n'est pas instantanée. Elle dure un certain temps pendant lequel l'horloge 37 continue d'émettre ses impulsions. Or pendant toute cette durée de codage, le détecteur est incapable de prendre en compte une impulsion suivante. Si la durée d'une impulsion est faible, et si la durée de cette quantification est peu importante relativement aux activités faibles, elle devient par contre très perturbante lorsque l'activité est forte. Pour éviter cet inconvénient on neutralise l'horloge 37 pendant le codage. Son fonctionnement est validé par une connexion 39 qui reçoit un signal en provenance du codeur 33 et qui invalide, pendant toute la durée de ce codage, le fonctionnement de cette horloge 37. En conséquence le temps pris en considération dans le compteur de temps 40 n'est que le temps actif.

En outre il peut être utile dans certaines circonstances de mesurer l'activité d'une émission particulièrement peu active alors qu'on est par ailleurs en présence d'une émission fort active. Par exemple, figure 2, on peut chercher à mesurer la faible activité dans une bande d'énergie 41 alors que l'on sait être en présence d'une forte activité dans la bande 3. Si on n'y prend pas garde cette activité 3 risque d'être tellement forte que son registre affecté arrivera en saturation rapidement, ce qui provoquera le décalage à droite, la division par deux de tous les registres, y compris du registre correspondant à la bande de faible activité 41. En conséquence cette faible activité sera connue d'une manière imprécise. De manière à éviter cet inconvénient on place en parallèle avec la mémoire principale 36 une mémoire auxiliaire 42 dans laquelle ont été préchargées des adresses de zones d'intérêt, c'est-à-dire des adresses correspondant aux registres autorisés à provoquer le décalage à droite en cas de saturation. Les registres non autorisés restent simplement en saturation si leur taux de comptage dépasse le taux de comptage des registres autorisés. Cette mémoire auxiliaire valide le fonctionnement du registre de lecture 38. Ce registre ne provoque donc le décalage à droite et la compensation qui si la saturation concerne uune zone d'intérêt.

Dans des applications de surveillance, l'analyseur d'amplitude peut être placé hors du contrôle d'un opérateur. Il peut être relié à des moyens de transmission 46, notamment des moyens radio, pour transmettre les résultats de ses mesures à un système central 47 de gestion.

En fonctionnement esclave, le système 47 interroge, chacun à leur tour, tous les analyseurs d'amplitude qui sont sous sa dépendance. Mais de préférence les analyseurs d'amplitude de l'invention comportent un comparateur 48 à seuil S pour mesurer en permanence l'état de chacune des voies de l'analyseur et pour se mettre automatiquement en émission à destination du système 47 dès que l'une de leurs voies, en particulier celles situées dans les zones d'intérêt, a dépassé ce seuil de mesure. Le fonctionnement en mode esclave ne permettrait pas de déterminer à quel moment s'est produit un phénomène anormal.

En mode maître en revanche, cette connaissance en temps réel de l'apparition d'un phénomène anormal peut être affichée immédiatement. Ce mode de fonctionnement découle du fait que les registres correspondant aux différents canaux ne sont plus de simples échelles de comptage mais des ictomètres. L'analyseur fonctionne sous le contrôle d'un séquenceur 49 qui reçoit les instructions du système central 47 ou de la détection du dépassement du seuil S. Le séquenceur 49 couplé au registre d'adresse 34 organise la lecture et la transmission du contenu des registres mémoire de la mémoire 36. Dans une application particulière, l'appareil est muni d'un dispositif de visualisation 43 recevant les adresses des bandes d'énergie d'une part et le résultat du dispositif 14 d'autre part. Ce dispositif de visualisation peut alors présenter les résultats de la mesure sous une forme comparable à celle évoquée sur la figure 2 (mais sans les fluctuations).

L'invention n'est pas limitée au cas du ratiomètre décrit de la page 10 ligne 27, à la page 13 ligne 23, notamment dans son application à un ictomètre, et au cas de l'analyseur d'amplitude présenté ensuite.

Comme déjà précisé en introduction (page 6 lignes 22 à 27) elle englobe des montages permettant la comparaison de deux grandeurs converties en deux fréquences, de trains d'impulsions aléatoires, par exemple dans le domaine nucléaire, et/ou de trains d'impulsions périodiques, d'horloge par exemple.

Le registre le plus plein à chaque instant est celui qui reçoit le signal le plus grand (fréquence la plus élevée) ; l'égalité des grandeurs (ou fréquences) est signalée par l'égalité des contenus des registres, ce qui conduit à la fonction discriminateur d'amplitude (ou de fréquence).

Accompagné d'une visualisation, par diodes électroluminescentes par exemple, du contenu des registres, un tel dispositif peut servir à une signalisation ou à une alarme ; suivi d'une commande de rétroaction, il peut asservir une grandeur à une consigne.

## Revendications

1. Comparateur (6-25) numérique comportant :
- un premier registre (6) muni d'une entrée (7) dite de comptage (8) pour recevoir et comptabiliser les impulsions d'un premier signal (9) impulsionnel représentatif d'une grandeur fixe ou évolutive, et d'une entrée dite de décalage à droite (11) pour effectuer une division du nombre (N) des impulsions comptabilisées, caractérisé en ce qu'il comporte :

- un deuxième registre (13) identique au premier pour recevoir un deuxième signal impulsionnel représentatif d'une deuxième grandeur fixe ou évolutive,

- des moyens (15) pour prendre en compte une mise en saturation de l'un ou l'autre des deux registres, et

- des moyens (16) pour effectuer en même temps le décalage à droite de ces deux registres au moment de cette saturation.

2. Ratiomètre faisant application du comparateur selon la revendication 1, caractérisé en ce qu'il comporte en outre :

- des moyens (14) pour effectuer le rapport du contenu (N) du premier registre par le contenu (T) du deuxième registre.

3. Ratiomètre selon l'une quelconque des revendications 1 et 2, caractérisé en ce que les moyens pour effectuer les décalages à droite comportent des moyens (16, 24, 25) associés à des moyens (23) pour ajouter une unité dans les registres avant d'effectuer ce décalage à droite.

4. Comparateur selon l'une quelconque des revendications 1 à 3, caractérisé en ce qu'il comporte une série de voies (6, 13, 26) de mesure, chaque voie comportant un registre (26) identique au premier registre pour comptabiliser un nombre d'événements dans cette voie.

5. Ratiomètre selon l'une quelconque des revendications 1 à 3, caractérisé en ce qu'il comporte une série de voies (6, 13, 26) de mesure, chaque voie comportant un registre (26) identique au premier registre pour comptabiliser un nombre d'événements dans cette voie.

6. Analyseur d'amplitude multivoie comportant un discriminateur (33) multivoie, caractérisé en ce qu'il comporte un ratiomètre selon la revendication 5, en ce que le deuxième registre (40) reçoit un signal dépendant du temps et les autres registres constituent les voies de l'analyseur, et en ce que le discriminateur discrimine (33) une bande d'amplitude d'un signal afin de transformer chaque voie en un ictomètre.

7. Analyseur selon la revendication 6, caractérisé en ce qu'il comporte des moyens (48) pour transmettre automatiquement ces mesures lorsqu'elles dépassent un certain seuil (S).

8. Analyseur selon l'une quelconque des revendications 6 et 7, caractérisé en ce qu'il comporte des moyens (42) pour neutraliser les effets d'une activité trop importante dans l'une des bandes d'amplitude.

# FIG_1

En

2

3

1

t

# FIG_2

N

41  44  3  45

En

# FIG_3

N

4

5

EN

# FIG_4

FIG_5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| D,A | EP-A-0 208 602 (C.E.A.)<br>* Colonne 2, ligne 33 - colonne 3, ligne 19; figure 1A *<br>--- | 1 | G 06 F 7/62<br>H 03 K 5/26<br>G 01 R 23/10 |
| A | EP-A-0 061 366 (VEGLIA)<br>* Texte relatif à la figure 1; figure 1 *<br>----- | 1,2 | |
| | | | **DOMAINES TECHNIQUES RECHERCHES (Int. Cl.4)**<br><br>G 06 F 7/00<br>H 03 K 5/00<br>G 01 R 23/00 |

**Le présent rapport a été établi pour toutes les revendications**

| Lieu de la recherche | Date d'achèvement de la recherche | Examinateur |
|---|---|---|
| LA HAYE | 14-03-1989 | NUSSBAUMER C.P. |

EPO FORM 1503 03.82 (P0402)